# EUROPEAN PATENT APPLICATION

(11) **EP 0 521 546 A1**
(43) Date of publication of application: **07.01.1993**
(21) Application number: 92201710.8
(22) Date of filing: 12.06.1992
(51) Int. Cl.: H03G 3/00, G01D 5/252

(54) **Controller for adjusting a control signal of an electronic apparatus**

(30) Priority: 01.07.1991 US 723990
(71) Applicant: DELCO ELECTRONICS CORPORATION, Kokomo Indiana 46902 (US)
(72) Inventor: Bironas, Dennis Keith, Kokomo, Indiana 46902 (US); Robarge, Wilbur Allen, Greentown, Indiana 46936 (US); Bradley, James Ray, Peru, Indiana 46970 (US)
(74) Representative: Denton, Michael John

(57) **Abstract**

A microprocessor based radio controller (28) has a rotary volume switch (24) with a plurality of contacts (32) which are coupled to the microprocessor (28) to indicate when each contact (32) is made and the direction of switch movement. The microprocessor (28) counts the number of contact events to determine the amount of switch movement. A ROM (36) stores at least one look-up table which converts the amount of switch movement to a volume increment and at each switch event the volume is changed according to the volume increment and the direction of switch movement.

## Description

This invention relates to a controller for adjusting a control signal for an electronic apparatus and to a method of adjusting an output signal produced in response to movement of a switch.

Radios or sound systems generally use push-button or rotary controls to control manually the system operation. push-buttons offer a quick preset response but are not versatile in that values between the preset values are not available. Conventional analogue controls such as rotary potentiometers or variable resistors, on the other hand, have the advantage of being infinitely adjustable but have some drawbacks as well. Over time the potentiometer will gather surface film and accumulate dust and become noisy, open-circuited or operate intermittently. When used with a microprocessor an analogue-to-digital converter is needed to convert voltage to a digital value. Modern radios, particularly in automotive applications, tend to use microprocessor control technology and thus it is desirable to have controls which easily interface with a microprocessor and take advantage of its superior control abilities.

It is known to use a rotary switch with a digital output as a radio tuner in a microprocessor controlled system. Such a switch can be rotated in either direction to close switch contacts at fixed angular increments, each contact outputting one of three digital numbers. By evaluating the change in the numbers during rotation, the microprocessor can determine the direction of rotation and the amount of rotation, and change the tuning signal accordingly. This is accomplished without noise or other effects of ageing. A disadvantage of this arrangement is that each angular increment must result in a signal change small enough to tune to every station, and consequently much rotation is required to traverse the entire tuning range of the radio. Such a limitation is particularly annoying in the case of a volume control. It is desirable that a change in the volume to reach an acceptable sound level can be effected rapidly, for example when first turning on the system, even though the previous user had set the volume to a much different level. It is also desirable to be able to make small volume adjustments. Thus, it is desired to have both fine and coarse control with the same control switch. In other applications another type of response may be required, for example a logarithmic or other non-linear function.

The present invention seeks to provide an improved controller.

According to an aspect of the present invention, there is provided a controller for adjusting a control signal for an electronic apparatus as specified in claim 1.

The invention can provide a digital controller which is programmable to achieve a desired response in accordance with the application.

A preferred embodiment includes a controller for an electronic system comprising a rotary switch movable to a plurality of positions and having at least three different digital outputs at the said positions; a ROM storing a look-up table containing control increment values as a function of the amount of switch movement; means periodically sampling the switch output for determining the direction and amount of switch movement and for looking up in the ROM table the increment value corresponding to the amount of switch movement; and means for changing a control signal in accordance with the increment value and the direction of rotation.

According to another aspect of the present invention, there is provided a method of adjusting an output signal produced in response to movement of a switch as specified in claim 7.

In a preferred embodiment, the method is carried out in a controller having a manually operated rotary switch having at least three contacts and a wiper selectively engaging the contacts during switch rotation thereby to generate a digital signal indicative of which contact is engaging the wiper; the method of controlling a digital output signal in response to switch rotation comprising the steps of reading the digital signal which reflects switch position; detecting change of the digital signal; determining the direction of switch rotation from the change of the digital signal; counting the number of detected changes during switch movement; converting the number of changes to a control increment; and changing the output signal by the amount of the control increment in accordance with the direction of rotation.

An embodiment of the present invention is described below, by way of illustration only, with reference to the accompanying drawings, in which:
Figure 1 is a block diagram of a radio system adapted for use with an embodiment of the present invention;
Figure 2 is a schematic diagram of an embodiment of switch and microprocessor based controller for the system of Figure 1;
Figure 3 is a flow chart representing an embodiment of program for controlling the microprocessor of Figure 2; and
Figure 4 is a flow chart representing a subroutine of the program of Figure 3 for selecting a look-up table.

While the ensuing description is directed to a controller which was designed specifically as a radio volume controller, the embodiment is also applicable to other microprocessor based systems. The use of a commercially available rotary switch which yields outputs that can be tailored by a ROM look-up table and used with software control is useful for many different applications.

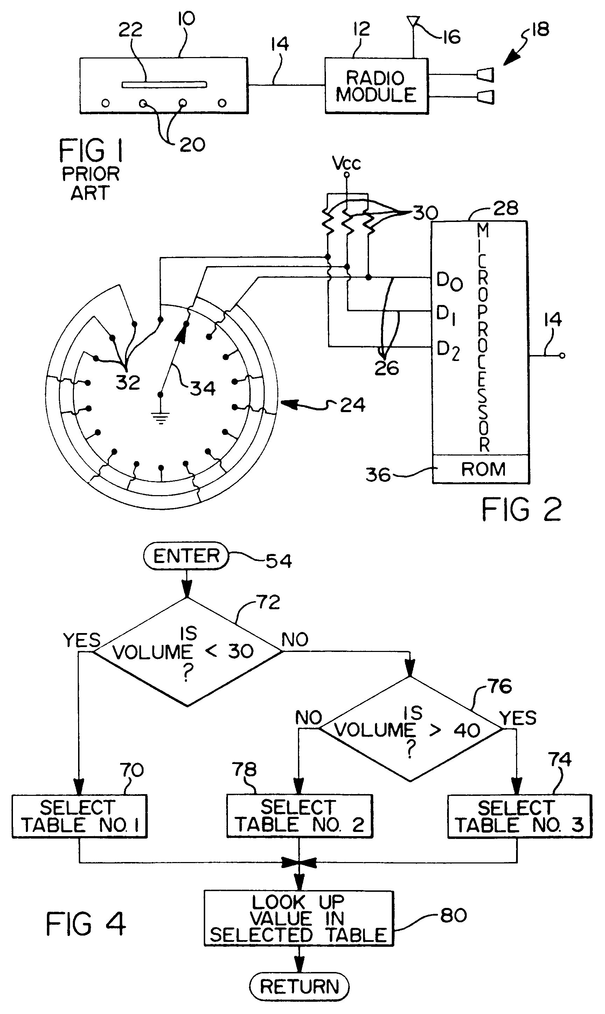

Referring to Figure 1, an automotive radio system includes a control head 10, a radio module 12 which is coupled to the head 10 by a data bus 14, an antenna 16 coupled to the module 12 and speakers 18, also connected to the module 12. The tuning of the module 12 as well as volume, fade and balance or other functions is controlled by the head 10 which sends control signals to the module 12 in the form of digital data via the bus 14. The head 10 includes control knobs 20 for manual selection of each function and a display 22 which is used to show at least the chosen radio frequency, but may also depict graphically the volume and other functions, in addition to time.

Digital signals carried by the bus communicate to the module 12 any settings input by operator adjustment of a knob 20. The signal for volume control, for example is a number from 0 to 63 with high numbers corresponding to a high volume. Thus, by changing the digital volume signal, the head 10 controls the module 12 to change the volume accordingly. The same method is used for tuner control.

Figure 2 shows a volume control switch 24 coupled by three lines 26 to inputs D₀, D₁ and D₂ of a microprocessor 28. Each line is connected to a power supply V_{cc} through a respective resistor 30. The switch 24 is arranged to connect to ground any one of the lines 26, such that in use the lines 26 provide positive voltages to two of the inputs D₀-D₂ and zero volts to the third input. The microprocessor is programmed to respond to changes in the inputs D₀-D₂ to determine the correct digital signal to place on the bus 14 in response to a change of input.

The switch 24 includes a circular array of 18 contacts 32 spaced 20° apart from one another with every third contact coupled to a given one of the lines 26. A grounded wiper 34 rotatably controlled by a knob 20 is movable from one contact 32 to the next in either direction without limit on the amount of rotation, thereby advancing the inputs through the sequence of digital signals 0 1 1, 1 0 1, 1 1 0, 0 1 1 and so on for knob rotation in the clockwise direction and through the reverse sequence for rotation in the other direction. Thus, by decoding the sequence of the numbers produced, the microprocessor 28 can determine the direction of rotation of the wiper 34 and make a suitable change on the control bus for each time a new input is received. Only valid inputs are considered; i.e., the 1 1 1 condition when the wiper is traversing between contacts is ignored. A mechanical detent (not shown) on the switch causes the wiper 34 to rest on each contact 32. Thus the wiper "clicks" to each contact 32 in turn, and each click corresponds to a 20° change in the wiper position. The term "click" is used herein to mean the switch position change event.

As so far described, the Figure 2 arrangement is already known and is incorporated in commercially available radios. For each click of the switch in such prior art systems, the control signal on the bus 14 changes by an increment of 1 in either direction, according to the direction of rotation of the wiper 34, to obtain fine control. For the purposes of the embodiment described herein, the microprocessor 28 includes a read only memory (ROM) 36 containing one or more look-up tables or conversion tables which are addressed by the number of clicks accumulated by the microprocessor. Each table contains a conversion function which dictates the increment size for the change of the control signal on bus 14. A variety of control characteristics can be programmed into the tables to get special results such as faster changes, logarithmic functions, etc. The microprocessor 28 is operated to increment its output according to the movement of the wiper 34 and the conversion function, or even to select the appropriate conversion function where more than one look-up table is provided.

A conversion table stores the output increment size for each number of input clicks. For example, one click yields an increment of one; two through six clicks each yield an increment of two; and seven through seventeen clicks each yield an increment of one. This allows fine adjustment for one click, faster adjustment for a moderate number of clicks, and slower adjustment for a high number of clicks. A portion of the table is shown in the following chart, which also indicates the cumulative or net change.

| CLICKS | INCREMENT | NET CHANGE |
|---|---|---|
| 1 | 1 | 1 |
| 2 | 2 | 3 |
| 3 | 2 | 5 |
| 4 | 2 | 7 |
| 5 | 2 | 9 |
| 6 | 2 | 11 |
| 7 | 1 | 12 |

If a rapidly increasing conversion rate was desired, the conversion function might be: one click yields on increment of one; two clicks each yield two, three clicks each yield four, four clicks each yield eight, and so on. The changes are cumulative so that at two clicks the total change is three, at three clicks the total change is seven, and so on, as shown in the following chart.

| CLICKS | INCREMENT | NET CHANGE |
|---|---|---|
| 1 | 1 | 1 |
| 2 | 2 | 3 |
| 3 | 4 | 7 |
| 4 | 8 | 15 |

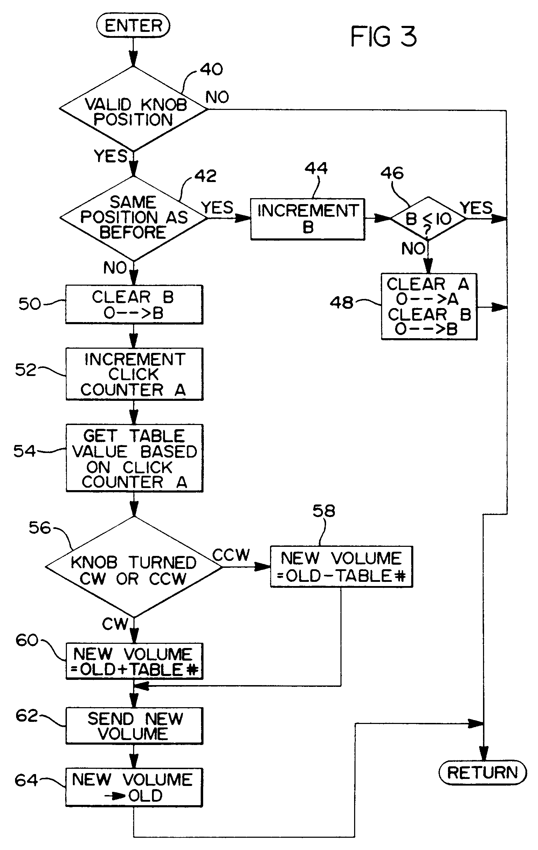

The flow chart of Figure 3 represents a computer program which is used to accomplish the detection of the number of clicks and the look-up of the proper conversion amount. In the description of the flow chart, the reference numerals nn on the blocks are represented within angled brackets 〈nn〉 so as to refer to the functions of the blocks. The main radio control loop runs the volume routine every 5 milliseconds. At this rate, every click of the switch will be detected even when the switch is turned rapidly. This is important, since if a single click is missed, the routine may be misled to detect an incorrect direction of movement of the wiper 34 and the volume change could be in the wrong direction. In each loop a valid knob position is tested 〈40〉. If the inputs to the microprocessor are not 0 1 1, 1 0 1, or 1 1 0 the program returns to the main loop. If the knob position is valid, it is tested for a change of position 〈42〉. If the position is the same as in the previous loop, a counter B is incremented 〈44〉 and if the counter contents B is less than ten 〈46〉, the control returns to the main loop. If the counter reaches ten, indicating that 50 milliseconds have elapsed since the counter was reset, the counter B and a counter A are cleared to zero before the routine returns to the main loop 〈48〉.

If the switch position has changed since the last loop 〈42〉, the counter B is cleared 〈50〉 and the click counter A is incremented by one count 〈52〉. The clearing of counter B when a click is detected assures that counter B will not complete its count for at least another 50 milliseconds, allowing time for still another click to be registered. The number of clicks accumulated in the counter is used to access a conversion table to find the volume increment 〈54〉. A routine compares the current microprocessor input to that of the previous click to decide in which direction the knob is turning 〈56〉, that is clockwise or counter-clockwise. If it has turned counter-clockwise, the new volume signal is the old volume less the volume increment from the table 〈58〉. On the other hand, if the knob has moved clockwise, the new volume is the old volume plus the volume increment 〈60〉. The new volume is output on the control bus 〈62〉 to effect the volume change. The new volume value is assigned to the old volume 〈64〉 and the routine returns to the main loop. Thus, each time the counter A is incremented, the volume is updated by the table value corresponding to the accumulated count. By tailoring the table to a particular application, a desired rate of volume change can be obtained.

The counter B is used to detect that the knob rotation has stopped and the counter A is cleared in readiness for another rotation. It is assumed that continued switch rotation will result in a less than 50 millisecond time lapse between clicks. If, in fact, the switch rotation has not stopped but is continuing so slowly that counter B reaches a count of ten after each click, then each click will result in a counter A count of one which results in a volume increment of one for fine adjustment.

More than one table can be stored in the RAM and one of them can be selected for use on the basis of one or more parameters. Figure 4 is an example of the use of volume for table selection, in which a volume range of 0-63 is divided into high, medium and low ranges and a different table is selected for each range. Thus, the table value subroutine 54 of Figure 3 would comprise selecting table no. 1 〈70〉 if the volume is less than 30 〈72〉, selecting table no. 3 〈74〉 if the volume is greater than 40 〈76〉, and otherwise selecting table no. 2 〈78〉. Then, the selected table is used to look up the volume increment value on the basis of the value of counter A 〈80〉. It will be appreciated that other parameters such as direction of knob rotation could be used alone or in logical combination with other parameters for table selection.

In summary, the microprocessor based radio controller 28 embodies at least one look-up table which is used to convert the amount of switch rotation to a control increment. The table is tailored for a given application to achieve a desired response to switch rotation. The embodiment can be used in other digital systems having a switch input where a non-linear response to switch movement is desired.

## Claims

1. A controller for adjusting a control signal for an electronic apparatus comprising a switch (24) movable to a plurality of positions (32) and adapted to provide a different output (26) at said positions; a memory (36) for storing a look-up table containing a plurality of control increments; processing means (28) for periodically sampling the switch output to determine movement of the switch by sensing when the output has changed, the processing means being adapted to determine from a change in the output of the switch the direction of movement of the switch, to obtain a count of the number of positions to or through which the switch is moved and at each new switch position to obtain from the look-up table a control increment corresponding to the count obtained, and to adjust the control signal on the basis of the obtained control increment and the direction of movement of the switch.

2. A controller according to claim 1, wherein the switch (24) is adapted to provide at least three different digital outputs at said positions.

3. A controller according to claim 1 or 2, wherein the processing means (28) is adapted to determine that movement of the switch has ceased when no change in the switch output has occurred for a predetermined number of sampling periods, and to set the obtained count to zero when it is determined that movement of the switch has ceased.

4. A controller according to claim 1, 2 or 3, wherein the memory includes a plurality of look-up tables, each containing a plurality of control increments based upon a function of the amount of switch movement; and comprising selecting means (28) responsive to an operating parameter of the electronic apparatus for selecting one of the look-up tables for use by the processing means, the control signal being adjustable on the basis of the operating parameter and the switch movement.

5. A controller according to any preceding claim, wherein the switch (24) is a rotary switch rotatable in a clockwise and/or counter-clockwise direction.

6. A controller according to any preceding claim, wherein the controller is adapted to adjust the volume of sound output by a sound system, the control signal being a volume signal, the switch (24) being a volume control switch, the or each look-up table containing a plurality of volume increments.

7. A method of adjusting an output signal produced in response to movement of a switch, which switch (24) includes at least three contacts (32) and a wiper (34) adapted to engage the contacts selectively during movement of the switch and to provide a wiper signal indicative of which contact is engaged by the wiper; the method comprising the steps of reading the wiper signal, detecting a change in the wiper signal, determining the direction of switch movement from the change in the wiper signal, obtaining a count of the number of detected changes during switch movement, converting the obtained count to a control increment, and adjusting the output signal on the basis of the control increment and the direction of movement of the switch.

8. A method according to claim 7, including the steps of measuring the time elapsed between changes in the wiper signal, and resetting the obtained count to zero when the time elapsed exceeds a set value.

9. A method according to claim 7 or 8, including the steps of providing a conversion table in which the control increment is provided as a function of the number of changes in the wiper signal, and converting the obtained count to a control increment on the basis of the conversion table.

10. A method according to claim 7 or 8, including the steps of providing a plurality of conversion tables, in which in each table the control increment is provided as a function of the number of changes in the wiper signal, selecting a table on the basis of the output signal, and converting the obtained count to a control increment on the basis of the selected conversion table.
